# EUROPEAN PATENT SPECIFICATION

(11) **EP 2 301 742 B1**
(45) Date of publication and mention of the grant of the patent: **15.01.2014**
(21) Application number: 10184073.4
(22) Date of filing: 16.07.2004
(51) Int. Cl.: B29C 67/00, B29C 41/12, C09D 7/02, C09D 7/12, G03F 7/00

(54) **Viscosity reducible radiation curable resin composition**
VISKOSITÄTSREDUZIERBARE, DURCH BESTRAHLUNG HÄRTBARE HARZZUSAMMENSETZUNG
COMPOSITION DE RESINE DURCISSANT AU RAYONNEMENT DONT LA VISCOSITE PEUT ETRE DIMINUEE

(30) Priority: 23.07.2003 US 489121 P
(43) Date of publication of application: 30.03.2011
(62) Divisional of application: 04774825.6
(73) Proprietor: DSM IP Assets B.V., 6411 TE Heerlen (NL)
(72) Inventor: You, Xiaorong, Bear, DE 19701 (US)
(74) Representative: Jansen, Cornelis Marinus

(56) References cited:
- EP-A- 0 499 485
- WO-A1-03/016217
- WO-A2-02/064689
- US-A- 6 099 787
- US-A1- 2002 198 289

## Description

### Field of the invention

The Invention relates to viscosity reducible radiation curable resin compositions.

### Background in the invention

Viscosity reducible radiation curable resin compositions are known from US 5,474,719 (which is incorporated herein by reference). Compositions have been disclosed comprising materials that induce thixotropic flow behavior. The compositions have a high viscosity at a low shear rate (for example 5,440 centipoise at 3 rpm, in a Brookfield viscosity experiment), and a much lower viscosity at a higher shear rate (for example 1,420 centipoise at 30 rpm). The difference in viscosity (centipoise) reported is between about 2 and 4 at these shear rates. These compositions are pastes in the absence of shear. US 20020195747 discloses a new solid freeform fabrication apparatus to form three-dimensional objects from highly viscous paste-like materials. These pastes contain fillers and have viscosities of greater than 10,000 centipoise at ambient conditions. These paste materials cannot be handled in an ordinary stereolithography machine, designed to handle liquid resins.

### Object of the Invention

It is an object of the present invention to provide radiation curable compositions that contain an inorganic filler, show thixotropic behavior and have a low yield stress. These compositions preferably show excellent storage and application stability.

It is another object of the present invention to provide a composition that has thixotropic characteristics, contains at least one filler, and can be applied in a conventional SL-machine to make three dimensional objects.

### Summary of the Invention

The present invention relates to a viscosity reducible radiation curable composition as defined in claim 1.

### Detailed description of the invention

The compositions of the present invention are radiation curable and contain at least one radiation curable component. Examples of radiation curable components are cationically polymerizable components, and radical polymerizable components.

### (A) Cationic polymerizable component

Cationic polymerizable component (hereinafter also referred to as component (A)) is an organic compound that polymerizes or crosslinks in the presence of a cationic polymerization initiator when irradiated with light. Examples of cationic polymerizable components include epoxy compounds, oxetane compounds, oxolane compounds, cyclic acetal compounds, cyclic lactone compounds, thiirane compounds, thietane compounds, vinyl ether compounds and cyclic thloether compounds. Among these compounds, the presence of epoxy compounds and/or oxetane compounds is preferred, because the curing rate of the prepared resin composition is high, and the cured resin obtained from the resin composition has good mechanical properties.

Epoxy compounds which can be used as the component (A) include bisphenol A diglycidyl ether, bisphenol F diglycidyl ether, bisphenol S diglycidyl ether, brominated bisphenol A diglycidyl ether, brominated bisphenol F diglycidyl ether, brominated bisphenol S diglycidyl ether, epoxy novolak resin, hydrogenated bisphenol A diglycidyl ether, hydrogenated bisphenol F diglycidyl ether, hydrogenated bisphenol S diglycidyl ether, 3,4-epoxycyclohexylmethyl-3',4'-epoxycyclohexane carboxylate, 2-(3,4-epoxycyclohexyl-5,5-spiro-3,4-epoxy) cyclohexane-metha-dioxane, bis(3,4-epoxycyclohoxylmethyl) adipate, vlnylcyclohexene oxide, 4-vinylepoxycyclohexane, bis(3,4-epoxy-6-methylcyclohexyl-methyl) adipate, 3,4-epoxy-6-methyloyclohexyl-3',4'-epoxy-6'-methyl cyclohexane carboxylate, methylenebis(3,4-epoxycyclohexane), dicyclopentadiene diepoxide, ethylene glycol di(3,4-epoxycyclohexylmethyl) ether, ethylene bis(3,4-epoxycyclohexanecarboxylate), epoxy-hexahydrodloctyl phthalate, epoxyhexahydrophthalic acid di-2-ethylhexyl, 1,4-butanediol diglycidyl ether, 1,6-hexanediol diglycidyl ether, glycerol triglycidyl ether, trimethylolpropane triglycidyl ether, polyethylene glycol diglycidyl ether, polypropylene glycol diglycidyl ether; polyglycidyl ether of polyether polyol obtained by adding one or more kinds of alkylene oxide to an aliphatic polyhydric alcohol such as ethylene glycol, propylene glycol, and glycerol; diglycidyl ester of an aliphatic head chain dibasic acid; mono glycidyl ether of aliphatic higher alcohol; phenol, cresol, and butyl phenol and a monoglycidyl ether of the polyether alcohol obtained by adding an alkylene oxide to these; glycidyl ester of a higher fatty acid; epoxidated soybean oil, epoxy stearic acid butyl, epoxy stearic acid octyl, epoxidated linseed oil, and epoxidated polybutadiene, for example.

Among these compounds, bisphenol A diglycidyl ether, bisphenol F diglycidyl ether, hydrogenated bisphenol A diglycidyl ether, hydrogenated bisphenol F diglycidyl ether, 3,4-epoxycyclohexylmethyl-3',4'-epoxycyclohexane carboxylate, bis(3,4-epoxycyclohexylmethyl) adipate, 1,4-butanediol diglycidyl ether, 1,6-hexanediol diglycidyl ether, glycerol triglycidyl ether, trimethylolpropane triglycidyl ether, polyethylene glycol diglycidyl ether, and polypropylene glycol diglycidyl ether are preferred.

Examples of oxetane compounds are trimethylene oxide, 3,3-dimethyl oxetane, 3,3-dichloro methyl oxetane, 3-ethyl-3-phenoxy methyl oxetane, bis(3-ethyl-3-methyloxy) butane, 3-ethyl-3-hydroxymethyloxetane, 3-(meth)allyloxymethyl-3-ethyloxetane, (3-ethyl-3-oxetanylmethoxy)methylbenzene, (3-ethyl-3-oxetanylmethoxy)benzene, 4-fluoro-[1-(3-ethyl-3-oxetanylmethoxy)methyl]-benzene, 4-methoxy-[1-(3-ethyl-3-oxetanylmethoxy)methyl]benzene, [1-(3-ethyl-3-oxetanylmethoxy)ethyl] phenyl ether, isobutoxymethyl (3-ethyl-3-oxetanylmethyl) ether, isobornyloxyethyl (3-ethyl-3-oxetanylmethyl) ether, isobornyl (3-ethyl-3-oxetanylmethyl) ether, 2-ethylhexyl (3-ethyl-3-oxetanyl methyl) ether, ethyldiethylene glycol (3-ethyl-3-oxetanylmethyl) ether, dicyclopentadiene (3-ethyl-3-oxetanylmethyl) ether, dicyclopentenyloxyethyl (3-ethyl-3-oxetanyl methyl) ether, dicyclopentenyl (3-ethyl-3-oxetanylmethyl) ether, tetrahydrofurfuryl (3-ethyl-3-oxetanylmethyl) ether, tetrabromophenyl (3-ethyl-3-oxetanylmethyl) ether, 2-tetrabromophenoxyethyl (3-ethyl-3-oxetanylmethyl) ether, tribromophenyl (3-ethyl-3-oxetanylmethyl) ether, 2-tribromophenoxyethyl (3-ethyl-3-oxetanylmethyl) ether, 2-hydroxyethyl (3-ethyl-3-oxetanyl methyl) ether, 2-hydroxypropyl (3-ethyl-3-oxetanylmethyl) ether, butoxyethyl (3-ethyl-3-oxetanylmethyl) ether, pentachlorophenyl (3-ethyl-3-oxetanylmethyl) ether, pentabromophenyl (3-ethyl-3-oxetanylmethyl) ether, bornyl (3-ethyl-3-oxetanylmethyl) ether, 2-phenyl-3, 3-dimethyl-oxetane, and 2-(4-methoxyphenyl)-3, 3-dimethyl-oxetane.

Oxetanes containing two or more oxetane rings in the molecule include, for instance, 3,7-bis(3-oxetanyl)-5-oxa-nonane, 3,3'-(1,3-(2-methylenyl)propanediylbis(oxymethylene))bis-(3-ethyloxetane), 1,4-bis[(3-ethyl-3-oxetanylmethoxy)methyl]benzene, 1,2-bis[(3-ethyl-3-oxetanylmethoxy)methyl]ethane, 1,3-bis[(3-ethyl-3-oxetanylmethoxy)methy]propane, ethylene glycol bis(3-ethyl-3-oxetanylmethyl) ether, dicyclopentenyl bis(3-ethyl-3-oxetanylmethyl) ether, triethylene glycol bis(3-ethyl-3-oxetanylmethyl) ether, tetraethylene glycol bis(3-ethyl-3-oxetanylmethyl) ether, tricyclodecanediyldimethylene (3-ethyl-3-oxetanylmethyl) ether, trimethylolpropane tris(3-ethyl-3-oxetanylmethyl) ether, 1,4-bis(3-ethyl-3-oxetanylmethoxy)butane, 1,6-bis(3-ethyl-3-oxetanylmethoxy)hexane, pentaerythritol tris(3-ethyl-3-oxetanylmethyl) ether, pentaerythritol tetrakis(3-ethyl-3-oxetanylmethyl) ether, polyethylene glycol bis(3-ethyl-3-oxetanylmethyl) ether, dipentaerythritol hexakis(3-ethyl-3-oxetanylmethyl) ether, dipentaerythritol pentakis(3-ethyl-3-oxetanylmethyl) ether, dipantaerythritol tetrakis(3-ethyl-3-oxetanylmethyl) ether, caprolactone-modified dipentaerythritol hexakis(3-ethyl-3-oxetanylmethyl) ether, caprolactone-modified dipentaerythritol pentakis(3-ethyl-3-oxetanylmethyl) ether, ditrimethylolpropane tetrakis(3-ethyl-3-oxetanylmethyl) ether, ethoxylated bisphenol A bis(3-ethyl-3-oxetanylmethyl) ether, propoxylated bisphenol A bls(3-ethyl-3-oxetanylmethyl) ether, ethoxylated hydrogenated bisphenol A bis(3-ethyl-3-oxetanylmethyl) ether, propoxylated hydrogenated bisphenol A bis(3-ethyl-3-oxetanylmethyl) ether, ethoxylated bisphenol F (3-ethyl-3-oxetanylmethyl) ether.

The cationic polymerizable compounds can be used singly or in combinations of two or more.

The component (A) content of the resin composition of this invention can be within the range of 10 to 95 wt%, preferably 30 to 90 wt%, and more preferably 40 to 85 wt%.

### (B) Cationic photopolymerization initiator

When a cationically polymerizable component A is present, the composition preferably also contains a cationic photopolymerization initiator (B). In the compositions according to the invention, any type of photoinitiator that, upon exposure to actinic radiation, forms cations that initiate the reactions of the cationically polymerizable component (A) can be used. There are a large number of known and technically proven cationic photoinitiators for epoxy resins that are suitable. They include, for example, onium salts with anions of weak nucleophillcity. Examples are halonium salts, iodosyl salts or sulfonium salts, such as are described in published European patent application EP 153904 and WO 98/28663, sulfoxonium salts, such as described, for example, in published European patent applications EP 35969, 44274, 54509, and 164314, or diazonium salts, such as described, for example, in U.S. Patents 3,708,296 and 5,002,856. Other cationic photoinitiators are metallocene salts, such as described, for example, in published European applications EP 94914 and 94915.

A survey of other current onium salt initiators and/or metallocene salts can be found in "UV Curing, Science and Technology", (Editor S. P. Pappas, Technology Marketing Corp., 642 Westover Road, Starnford, Conn., U.S.A.) Or "Chemistry & Technology of UV & EB Formulation for Coatings, Inks & Paints", Vol. 3 (edited by P. K. T. Oldring). A preferred cationic photoinitiator (B) is an onium salt represented by the following general formula.

[R¹ₐR²_{b}R³_{c}R⁴_{d}Z]^{+m}[MXₙ]^{-m} (1)

In the above formula, the cation is onium; Z represents S, Se, Te, P, As, Sb, Bi, O, I, Br, Cl, or N=N; and R1, R2, R3 and R4 represent the same or different organic acid. a, b, c, and d are each an Integer from 0 to 3, (a+b+c+d) being equal to the valence of Z. M represents a metal or metalloid that is the central atom of the halide complex; B, P, As, Sb, Fe, Sn, Bi, Al, Ca, In, Ti, Zn, Sc, V, Cr, Mn, and Co, for example. X represents a halogen. m is the net electric charge of the halide complex ion. n is the number of halide atoms in the halide complex ion.

Examples of the anion (MXₙ) in the above general formula include tetrafluoroborate (BF₄⁻), hexafluorophosphate (PF₆⁻¹, hexafluoroantimonate (SbF₆⁻), hexafluoroarsenate (AsF₆⁻), and hexachloroantimonate (SbCl₆⁻).

In addition, onium salts having an anion represented by a general formula [MXₙ(OH)] can be used. Further, onium salts having other anions such as perchloric acid ion (ClO₄⁻), trifluoromethane sulfonic acid ion (CF₃SO₃⁻), fluorosulfone acid ion (FSO₃⁻), toluene sulfonic acid ion, trinitrobenzene sulfonic acid ion, and trinitrotoluene sulfonic acid ion can also be used.

The cationic photopolymerization initiators may be used singly or in combinations of two or more.

The component (B) content of the resin composition of this invention may be within the range of 0.1 to 10 wt%, preferably 0.2 to 5 wt%, and more preferably 0.3 to 3 wt%.

### (C) radical polymerizable component

The present Invention may comprise one or more free radical curable components, e.g. one or more free radical polymerizable components having one or more ethylenically unsaturated groups, such as (meth)acrylate (i.e. acrylate and/or methacrylate) functional components. The free radical polymerizable components may have one or more radically polymerizable groups. Non-limiting examples of monofunctional (meth)acrylates are isobornyl (meth)acrylate, lauryl (meth)acrylate, and phenoxyethyl (meth)acrylate.

Polyfunctional monomers which can be used for the component(C) are ethylene glycol di(meth)acrylate, dicyclopentenyl di(meth)acrylate, triethylene glycol diacrylate, tetra ethylene glycol di(meth)acrylate, tricyclodecanedlyldimethylene di(meth)acrylate, tris(2-hydroxyethyl) isocyanurate di(meth)acrylate, tris(2-hydroxyethyl) isocyanurate tri(meth)acrylate, caprolactone-modified tris(2-hydroxyethyl) isocyanurate tri(meth)acrylate, trimethylolpropane tri(meth)acrylate, ethylene oxide (hereinafter also referred to as EO for short)-modified trimethylolpropane tri(meth)acrylate, propylene oxide (hereinafter also referred to as PO for short)-modified trimethylolpropane tri(meth)acrylate, tripropylene glycol di(meth)acrylate, neopentyl glycol di(meth)acrylate, bisphenol A diglycidyl ether with (meth)acrylic acid adducts at both terminals, 1,4-butanediol di(meth)acrylate, 1,6-hexanediol di(meth)acrylate, pentaerythritol tri(meth)acrylate, pentaerythritol tetra(meth)acrylate, polyester di(meth)acrylate, polyethylene glycol di(meth)acrylate, dipentaerythritol hexa(meth)acrylate, dipentaerythritol penta(meth)acrylate, dipentaerythritol tetra(meth)acrylate, caprolactone-modified dipentaerythritol hexa(meth)acrylate, caprolactone-modified dipentaerythritol penta(meth)acrylate, ditrimethylolpropane tetra(meth)acrylate, EO-modified bisphenol A di(meth)acrylate, PO-modified bisphenol A di(meth)acrylate, EO-modified hydrogenated bisphenol A di(meth)acrylate, PO-modified hydrogenated bisphenol A di(meth)acrylate, EO-modified bisphenol F di(meth)acrylate, and (meth)acrylate of phenolnovolac polyglycidyl ether.

A polyfunctional monomer having three or more functional monomers for this purpose can be selected from for example any of the above described tri(meth)acrylate compounds tetra(meth)acrylate compounds, penta(meth)acrylate compounds, and hexa(metha)acrylate compounds. Among them, trimethylolpropane tri(meth)acrylate, EO-modified trimethylolpropane tri(meth)acrylate, dipentaerythritol hexa(meth)acrylate, dipentaerythritol penta(meth)acrylate, and ditrimethylolpropane tetra(meth)acrylate are especially preferable.

Monofunctional and polyfunctional monomers of component (C) may be used singly or in combinations of two or more, such that the amount of component (C) is preferably 5 to 50 wt%, alternatively 7 to 25 wt%, and more preferably 10 to 20 wt%.

### (D) Radical photopolymerization initiator

When a radically polymerizable component C is present, the composition preferably also contains a radical photopolymerization initiator (D). In the compositions according to the invention, any type of photoinitiator that, upon exposure to actinic radiation, forms radicals that initiate the reactions of the radically polymerizable component (C) can be used.

Radical photopolymerization initiators which can be used for the component (D) include acetophenone, acetophenone benzyl ketal, anthraquinone, 1-(4-isopropylphenyl)-2-hydroxy-2-methylpropan-1-one, carbazole, xanthone, 4-chlorobenzo-phenone, 4,4'-diaminobenzophenone, 1,1-dimethoxydeoxy-benzoin, 3,3'-dimethyl-4-methoxybenzophenone, thioxanethone compounds, 2-methyl-1-4-(methylthio) phenyl-2-morpholinopropan-2-one, 2-benzyl-2-dimethylamino-1-(4-morpholinophenyl)-butan-1-one, triphenylamine, 2,4,6-trimethylbenzoyl diphenylphosphine oxides, bis(2,6-dimethoxybenzoyl)-2,4,4-tri-methylpentyl phosphone oxide, benzyl methyl ketal, 1-hydroxycyclohexylphenyl ketone, 2-hydroxy-2-methyl-1-phenylpropan-1-one, fluorenone, fluorene, benzaldehyde, benzoin ethyl ether, benzoin propyl ether, benzophenone, Michler's ketone, 3-methylacetophenone, 3,3',4,4'-tetra(t-butylperoxycarbonyl) benzophenone (BTTB), and combination of BTTB and a color sensitizer such as xanthene, thioxanthene, cumarin, and ketocumarin, for example. Among these compounds, benzyl methyl ketal, 1-hydroxycyclohexylphenyl ketone, 2,4,6-trimethylbenzoyl diphenylphosphine oxides, and 2-benzyl-2-dimethylamino-1-(4-morpholinophenyl)-butan-1-one are especially preferable.

The radical photopolymerization initiators may be used singly or in combinations of two or more.

The component (D) content of the liquid of the resin composition of this invention is typically within the range of 0.01 to 10 wt% and preferably 0.1 to 8 wt%.

### (E) Filler

The filler (hereinafter also referred to as the component (E)) of the resin composition of this invention may be any substance without special limitation, but an inorganic substance is preferred from the point of view of the water-resisting capabilities and mechanical properties of the three dimensional objects made of the resin composition. The filler may be present as particles of any form, or for example as a powder.

For example, silica powder with an average particle size or fiber length of 1 to 50 µm, such as of fused silica and/or crystalline silica may be used. Another example of a suitable filler is fused and/or crystalline silica, of which the powder particles are spherical.

Inorganic filler substances other than silica powder include polymers, minerals, metals, metallic compounds, ceramics, or any combination thereof. Some polymers that may be used are thermoplastics such as ABS, Nylon, polypropylene, polycarbonate, polyethersulfate, and the like. Some metallic powders or particles that may be used are steel, steel alloy, stainless steel, aluminum, aluminum alloy, titanium, titanium alloy, copper, tungsten, tungsten carbide, molybdenum, nickel alloy, lanthanum, hafnium, tantalum, rhenium, rubidium, bismuth, cadmium, indium, tin, zinc, cobalt, manganese, chromium, gold, silver, and the like. Some ceramics that may be used are aluminum nitride, aluminum oxide, calcium carbonate, fluoride, magnesium oxide, silicon carbide, silicon dioxide, silicon nitride, titanium carbide, titanium carbonitride, titanium diboride, titanium dioxide, tungsten carbide, tungsten trioxide, zirconia, and zinc sulphide, and the like. Some rare earth mineral powders that may be used are cerium oxide, dysprosium oxide, erbium oxide, gadolinium oxide, holmium oxide, lutetium oxide, samarium oxide, terbium oxide, yttrium oxide, and the like, glass powder, alumina, alumina hydrate, magnesium oxide, magnesium hydroxide, barium sulfate, calcium sulfate, calcium carbonate, magnesium carbonate, silicate mineral, diatomaceous earth, silica sand, silica powder, oxidation titanium, aluminum powder, bronze, zinc powder, copper powder, lead powder, gold powder, silver dust, glass fiber, titanic acid potassium whiskers, carbon whiskers, sapphire whiskers, verification rear whiskers, boron carbide whiskers, silicon carbide whiskers, and silicon nitride whiskers.

The condition of the surface of the particles of the filler used and the impurities contained in filler from the manufacturing process can affect the curing reaction of the resin composition. In such cases, it is preferable to wash the filler particles or coat the particles with an appropriate primer as a method of improving the curing properties.

These inorganic fillers may also be surface-treated with a silane coupling agent. Silane coupling agents which can be used for this purpose include vinyl trichlorosilane, vinyl tris (β-methoxyethoxy) silane, vinyltriethoxy silane, vinyltrimethoxy silane, γ-(methacryloxypropyl)trimethoxy silane, β-(3,4-epoxycyclohexyl)ethyltrimethoxy silane, γ-glycydoxypropyltrimethoxy silane, γ-glycydoxypropylmethyl diethoxy silane, N-β(aminoethyl)-γ-aminopropyltrimethoxy silane, N-β-(aminoethyl)-γ-aminopropylmethyldimethoxy silane, γ-aminopropyltriethoxysilane, N-phenyl-γ-amino propyl trimethoxy silane, γ-mercaptopropyl trimethoxysilane, and γ-chloropropyltrimethoxy silane.

The above inorganic fillers may be used singly or in combination of two or more. By using inorganic fillers with different properties in combination, it is possible to impart the desirable properties derived from the fillers to the prepared resin composition. Further, the prepared resin composition can have a remarkably different fluidity if the grain size or fiber length distribution of the inorganic filler used is different, though the substance, the average grain size or fiber length, and the amount are the same. Therefore, by appropriately determining not only the average grain size or fiber length but also the grain size or fiber length distribution, or by using inorganic fillers of the same substance with different average grain sizes or fiber lengths in combination, the necessary amount of the filler and the fluidity and other properties of the prepared resin can be controlled as desired.

The component (E) content of the resin composition of this invention is within the range of 10-90 wt%, preferably 30 to 80 wt% and more preferably 50 to 70 wt% of the total composition.

### (F) Thixotropic agent

The resin composition of the present invention contains a material that acts as a thixotropic agent. Suitable thixotropic agents provide a stable resin, with no or limited settling of filler over time. Preferably the pH of the material is below pH 7, and it should have no or only limited influence on photospeed of the resins and mechanical properties of the parts made out of the resins by curing the resins with for example UV-light. Preferably the thixotropic agents show a fast recovery of viscosity, after application of shear in order to speed up the stereolithography process.

Examples of suitable thixotropic agents are polyvinylpyrrolidone (like PVP K-15, K30 and K-90), titanate coupling agents (like Ken-React LICA 38 and 55), aluminum distearate or aluminum tristearate, copolymers with acidic groups (like Disperbyk-111), compounds having ionic groups (like Control 3F SB, Centrol 3F UB and Emulmetik 120), fumed silica (like Aerosil 200), organic derivatives of castor oil (like Thixatrol 1, Thixatrol ST, Thixatrol GST and Thixcin R) and polyoxyethylene-polyoxypropylene block copolymers (like the Pluronic ® series). Preferably the thixotropic agent is chosen from the group consisting of Thixcin R, Thixatrol 1, Thixatrol GST, Thixatrol ST, Aluminum stearate 132 and 22, MPA 14, Ken react LICA 38 and KR 55. Most preferred are thixotropic agents from the group consisting of Thixcin R, Thixatrol 1, Thixatrol GST and Thixatrol ST.

Thixotropic agents are added In sufficient amounts to prevent settling of the filler. Typically, the amount of thixotropic agent is between 0,1 and 10 wt% (relative to the total of the composition), preferably between 0.5 and 5 wt%.

### (G) Flow aid

Addition of thixotropic agents in sufficient amounts to prevent settling of the filler, will generally give resins that have a high yield stress. The yield stress can be lowered, without adversely effecting the thixotropic and anti settling behavior of the resin, by addition of a flow aid. In accordance with the invention as flow aid polyalkyleneoxide modified polydimethylsiloxane (like Silwet L 7602) is added in an amount between 0.01 and 5 wt%, preferably between 0.02 and 1 wt%.

### Optional components and additives

The resin composition of this invention may contain optional components other than the components (A) to (G) described above, within the limits that these components do not impair the photo-curing properties of the resin composition. The optional components include photosensitizer (polymerization promotors) consisting of amine compounds such as triethanolamine, methyl diethanolamine, triethylamine, and diethylamine; photosensitizers consisting of thioxanethone, derivatives of thioxanethone, anthraquinone, derivatives of anthraquinone, anthracene, derivatives of anthracene, perylene, derivatives of perylene, benzophenone, benzoin isopropyl ether; and reactive diluents such as vinyl ether, vinyl sulfide, vinyl urethane, urethane acrylate, and vinyl urea, for example.

The resin composition of this invention may also contain various kinds of additives. Examples of suitable additives include resins or polymers such as epoxy resin, polyamide, polyamideimide, polyurethane, polybutadiene, polychloroprene, polyether, polyester, styrene/butadiene styrene block copolymer, petroleum resin, xylene resin, ketone resin, cellulose resin, fluorine containing oligomer, and silicon containing oligomer; polymerization Inhibitors such as for example phenothiazine, and 2,6-di-t-butyl-4-methyl phenol; polymerization initiation assistants, leveling agents, wettability improvers, surfactants, plasticizers, UV absorbers, silane coupling agents, resin particles, pigment, and dyes.

The resin composition of this invention can be prepared by mixing the above described components (A) to (D), (F) and (G), optional components, and additives into a homogenous resin solution and then dispersing the filler component (E) in the homogeneous resin solution. Other methods of mixing, for example wherein the order of addition of components is changed are also possible. These and other methods are generally known to the skilled man.

The invention also relates to a method for forming a three dimensional object comprising the steps of:
a) Coating a layer of a viscosity reduced composition on a surface;
b) Allowing said layer to become a viscosity reducible composition layer having a viscosity greater than said viscosity reduced layer;
c) Exposing said viscosity reducible layer to radiation imagewise by radiation means in order to photoform said layer imagewise;
d) Repeating steps a) through c) until the three dimensional object is being formed.

### Test methods

The following test method is used to measure the yield stress and viscosity vs. shear rate of paste samples of the present invention. Measurements are performed on a SR5 Stress Rheometer, mfg by Rheometric Scientific Inc. the following settings are used:
Test Type: Stress sweep in steady rotation mode.
Geometry: Parallel plate, 25 mm diameter and 1.0 mm gap.
Temperature: 25°C, regulated by a bottom Peltier plate.
Sweep mode: Logarithmic, 10 points per decade.
Initial Stress: 20 Pa.
Final Stress: 10⁴ Pa.
Maximum time per data point: 15 seconds.
Delay time: 10-second delay before starting test.

The technique for sample loading is standard, known by one skilled in rheometer use. When the sample has been loaded and excess material trimmed from the plate edges, the run is started. The run creates three kinds of graphs: (1) Shear rate vs. shear stress, log-log scales; (2) Shear stress vs. shear rate, both scales linear; and (3) Viscosity vs. shear rate, log-log scales. The yield point is defined as the point in the shear-rate vs shear stress curve (1) where the rate equals 10⁻² sec⁻¹. The yield stress value is defined as the shear stress at which the shear rate first exceeds 1 x 10⁻² sec⁻¹. The plot of viscosity vs. shear rate (3) does not come from a separate experiment, but from a replotting of data already present in the original data set. A set of points relating to shear stress and shear rate are already on hand. Viscosity is defined as shear stress divided by shear rate, so viscosity is calculated by the program and is available for plotting.

### Test method to determine the recovery time (example 2)

Recovery measurements were performed with a Rheometric Scientific ARES-LS dynamic mechanical analyzer equipped with a concentric cylinder geometry. The cylinder diameters were 25 and 27 mm, respectively.
Before loading into the concentric cylinder system the samples were manually stirred for at least 1 minute. After loading the sample, a so-called steady shear experiment was performed with a shear rate of 110 sec⁻¹ and a duration of 15 seconds. Immediately after this steady shear experiment, the instrument was switched to dynamic mode and a so-called time sweep with a fixed angular frequency of 1 rad/s and a strain amplitude of 0.3% was started. During this time sweep, the dynamic viscosity and the phase angle were monitored as a function of time to monitor the recovery of the sample structure. The test temperature was 23°C. The viscosity of a sample is considered as recovered, when the viscosity of the sample is at least 95% of the initial value of the viscosity.

### Determination of filler settling speed

The filler settling speed (or sedimentation rate) of the formulations is determined as follows: Test tubes (dimensions height 150mm, outer diameter 20mm and inner diameter 17mm) are filled with the freshly prepared paste-like compositions up to a level of 120mm (one tube for every composition). The test tubes are stored at room temperature in a draught-free place protected from light and the level of the clear solution on the top of the resin in each of the test tubes is measured every 24 hours. The settling speed is determined by measuring the settling during 15 days, and determining the average sedimentation per day with regression analysis.

### Ref. Example 1----Effect of flow aid on yield stress

### Ref.: = reference

A paste-like composition is prepared by mixing the below components.

| **Component** | **Chemical Name** | **Component** |
|---|---|---|
| UVR-1500 | 3,4-Epoxy Cyclohexyl Methyl-3,4-Epoxy Cyclohexyl Carboxylate | Epoxide |
| Heloxy 67 | 1,4-butanediol diglycidyl ether | Epoxide |
| SR-351 | 1,1,1-Trimethylolpropane triacrylate | Acrylate |
| DPHA | Dipentaerythritol hexaacrylate | Acrylate |
| Ir-184 | 1-Hydroxycyclohexyl phenyl ketone | Free Radical Initiator |
| CPI 6976 | Sulfonium,(thiodi-4,1-phenylene)bis[diphenyl-bis[(OC-6-11)hexafluoroantimonate(1-)]] | Cationic Initiator |
| 4-methoxyphenol | 4-methoxyphonol | Additive |
| Vinyltrimethoxysilane | Vinyltrimethoxysilane | Additive |
| NP-100 | Amorphous Silica Oxide | Filler |
| Aerosol 200 | Amorphous Silica Oxide | Filler |
| Thixatrol ST | Organic derivative of castor oil based additive | Thixatropic agent |
| Thixin R | Organic derivative of castor oil based additive | Thixotropic agent |
| LG-99 | Acrylic Polymer (Estron Chemical) | Flow aid |
| Modaflow 2100 | Ethyl acrylate-2-ethylhexyl acrylate copolymer | Flow aid |

A base composition is made by mixing 23.4 wt% UVR-1500, 8.74 wt% Heloxy 67, 3.91 wt% SR-351, 2.42 wt% DPHA, 0.02 wt% 4-methoxyphenol, 60.54 wt% NP-100, 0.41 wt% Aerosil 200 and 0.61 wt% vinyltrimethoxysilane. The base composition did not contain Ir-184 and CPI 6976, since these compounds are not needed for the rheology tests. Presence or absense of photoinitiators does not substantially change the rheology behavior of the resins. Absence of photoinitiators has the advantage of increased light stability of the resins during preparation and run of the rheology samples. Addition of (for example) 0.66 wt% Ir-184 and 3.79 wt% CPI 6976 gives UV-radiation curable resins, that can be cured with UV-radiation from for example a solid state laser. It is within the ability of the skilled man to change the amounts of photoinitiator to obtain the optimum photoresponse (like cure depth (Dp)) for his experiments.

Different amounts of thixotropic agents and flow aid are added to the base composition. Flow properties (yield stress, viscosity at shear rates 1, 10 and 100 (sec⁻¹) and filler settling speed) are measured according to the procedures mentioned before. The results are summarized below.

### Reference examples (not according to the invention):

| Semple ID: | Flowaid ID | Flow aid | Anti-settling ID | Anti-settling | Yield Stress | Viscosity at shear rate 1s⁻¹ (Pa-s) | Viscosity at shear rate 10s⁻¹ (Pa-s) | Viscosity at shear rate 100 s⁻¹ (Pa-s) | Settling Speed |
|---|---|---|---|---|---|---|---|---|---|
| | | wt% | | wt% | (Pa) | | | | (mm/day) |
| C1.1 | | 0,00 | Thix-ST | 0,50 | 725 | 2000 | 200 | 25 | 0.33 |
| C12 | | 0,00 | Thix-ST | 1,00 | 1200 | 4000 | 450 | 50 | 0 |
| C1.3 | | 0,00 | Thix-ST | 1,25 | 1500 | 4500 | 500 | 60 | 0 |
| C1.4 | | 0,00 | Thix-ST | 2,00 | 5000 | 6000 | 700 | 70 | 0 |
| C1.5 | | 0,00 | Thix-ST | 2,50 | 6200 | 7000 | 1000 | 150 | 0 |
| 1.1 | M-2100 | 0,03 | Thix-ST | 1,50 | 0 | 450 | 70 | 9 | 0 |
| 1.2 | M-2100 | 0,15 | Thix-ST | 1,50 | 0 | 450 | 70 | 9 | 0 |
| 1.3 | M-2100 | 0,03 | Thix-ST | 3,00 | 1000 | 1200 | 175 | 20 | 0 |
| 1.4 | M-2100 | 0,15 | This-ST | 3,00 | 400 | 900 | 100 | 12 | 0 |
| 1.5 | M-2100 | 0,20 | Thix-ST | 3,00 | 250 | 700 | 100 | 12 | 0 |
| 1.6 | LG-99 | 0,03 | Thix-ST | 1,50 | 1000 | 4000 | 447 | 50 | 0 |
| 1.7 | LG-99 | 0,15 | Thix-ST | 1,50 | 200 | 2350 | 288 | 35 | 0 |
| 1.8 | LG-99 | 0,03 | Thix-ST | 3,00 | 3000 | 6000 | 709 | 86 | 0 |
| 1.9 | LG-99 | 0,15 | Thix-ST | 3,00 | 900 | 3200 | 457 | 65 | 0 |
| 1.10 | LG-99 | 0,20 | Thix-ST | 3,00 | 400 | 2100 | 302 | 43 | 0 |
| C1.6 | | 0,00 | Th-R | 0,50 | 350 | 1,500 | 335 | 75 | 0.56 |
| C1.7 | | 0,00 | Th-R | 1,00 | 710 | 2,100 | 454 | 98 | 0.21 |
| C1.8 | | 0,00 | Th-R | 1,25 | 950 | 3,200 | 620 | 120 | 0 |
| C1.9 | | 0,00 | Th-R | 2,00 | 2100 | 4,000 | 762 | 145 | 0 |
| C1.10 | | 0,00 | Th-R | 2,50 | 3000 | 5,000 | 949 | 180 | 0 |
| 1.11 | M-2100 | 0,03 | Th-R | 1,50 | 245 | 1500 | 365 | 89 | 0 |
| 1.12 | M-2100 | 0,15 | Th-R | 1,50 | 0 | 1000 | 255 | 65 | 0 |
| 1.13 | M-2100 | 0,03 | Th-R | 3,00 | 1235 | 1890 | 439 | 102 | 0 |
| 1.14 | M-2100 | 0,15 | Th-R | 3,00 | 560 | 1300 | 314 | 76 | 0 |
| 1.15 | M-2100 | 0,20 | Th-R | 3,00 | 317 | 1100 | 271 | 67 | 0 |
| 1.16 | LG-99 | 0,03 | Th-R | 1,50 | 380 | 1790 | 438 | 107 | 0 |
| 1.17 | LG-99 | 0,15 | Th-R | 1,50 | 150 | 1520 | 362 | 86 | 0 |
| 1.18 | LG-99 | 0,03 | Th-R | 3,00 | 3200 | 3100 | 670 | 145 | 0 |
| 1.19 | LG-99 | 0,15 | Th-R | 3,00 | 672 | 1910 | 426 | 95 | 0 |
| 1.20 | LG-99 | 0,20 | Th-R | 3,00 | 490 | 1020 | 291 | 83 | 0 |

| | | | | | | | | | |
|---|---|---|---|---|---|---|---|---|---|
| Thix-ST = Thixatrol ST Th-R = Thixin R M-21 00 = Modalow 2100 | | | | | | | | | |

Most of the samples did not show any settling, except for samples C1, C6 and C7. Development of settling occurred as indicated below:

| Sample ID: | In the beginning (0 day) | After 1 day (mm) | After 2 day (mm) day | After 3 (mm) | After 4 day (mm) | After 8 day (mm) | After 15 day (mm) | Gradient of the regression line (mm/day) |
|---|---|---|---|---|---|---|---|---|
| C1.1 | 0 | 0 | 0 | 1 | 1,4 | 2,6 | 4,9 | 0.33 |
| C1.6 | 0 | 0.6 | 1.1 | 1.7 | 2.2 | 4.5 | 8.4 | 0.56 |
| C1.7 | 0 | 0.6 | 0.4 | 0.6 | 0.8 | 1.7 | 3.2 | 0.21 |
| All other exp. | 0 | 0 | 0 | 0 | 0 | 0 | 0 | 0 |

### Ref.- Example 2-Effect of Thixatropic Reagent And Flow Aid on Recovery Time

The recovery time of resins according to the invention is studied. 8 compositions from the example 1 have been subjected to a shear experiment, wherein the recovery of viscosity is studied after applying steady shear for a short period of time. The recovery time of each sample is determined after a first steady shear (during 1 sec) and again after applying 60 sec of a second shear. The recovery index is the recovery time after the second shear, divided by the recovery time after the first shear. A recovery index between 1 and 5 represents a composition having preferred recovery characteristics. Preferably the recovery index is between 1 and 2.

| example | Resin composition from exp. | Shear rate (1/S) | Time for Steady shear | Recovery time (Second) | Time for steady shear (Second) | Recovery time (Second) | Recovery Index |
|---|---|---|---|---|---|---|---|
| 2.1 | 1.1 | 116 | 1 | 55 | 60 | 76 | 1.38 |
| 2.2 | 1.2 | 116 | 1 | 78 | 60 | 112 | 1.44 |
| 2.3 | 1.11 | 116 | 1 | 66 | 60 | 123 | 1.86 |
| 2.4 | 1.12 | 116 | 1 | 85 | 60 | 167 | 1.96 |
| 2.5 | 1.6 | 116 | 1 | 105 | 60 | 198 | 1.89 |
| 2.6 | 1.7 | 116 | 1 | 134 | 60 | 258 | 1.93 |
| 2.7 | 1.16 | 116 | 1 | 128 | 60 | 236 | 1.84 |
| 2.8 | 1.17 | 116 | 1 | 152 | 60 | 278 | 1.83 |

## Claims

1. A viscosity reducible radiation curable composition for making three-dimensional objects comprising
5-70 wt% of a difunctional epoxy compound;
0.1-15 wt% of an acrylate having a functionality of larger than 2;
0.1-10 wt% of a thixotropic agent;
0.01-5 wt% of a flow modifier being polyalkyleneoxide modified polydimethylsiloxane;
10-90 wt% of a filler; and
at least one photoinitiator.

2. The composition according to claim 1, wherein the composition has the properties:
i) a yield stress value of < 1000 Pa,
ii) a viscosity (at a shear rate of 1 sec⁻¹) between 0 and 1500 Pa-sec, and
iii) a filler settling speed less than 0.3 mm/day.

3. The composition according to claim 1 or 2, wherein the difunctional epoxy compound is selected from the group consisting of bisphenol A diglycidyl ether, bisphenol F diglycidyl ether, hydrogenated bisphenol A diglycidyl ether, hydrogenated bisphenol F diglycidyl ether, 3,4-epoxycyclohexylmethyl-3',4'-epoxyeyclohexane carboxylate, bis(3,4-epoxycyclohexylmethyl)adipate, 1,4-butanediol diglycidyl ether, 1,6-hexanediol diglycidyl ether, polyethylene glycol diglycidyl ether, and polypropylene glycol diglycidyl ether.

4. The compositions according to any one of claims 1-3, wherein the acrylate having a functionality of larger than 2 is selected from the group consisting of trimethylolpropane tri(meth)acrylate, ethylene oxide-modified trimethylolpropane tri(meth)acrylate, dipentaerythritol hexa(meth)acrylate, dipentaerythritol penta(meth)acrylate, and ditrimethylolpropae tetra(meth)acrylate.

5. The composition according to any one of claims 1-4, wherein the thixotropic agent is selected from the group consisting of polyvinylpyrrolidone, titanate coupling agents, aluminum distearate, aluminum tristearate, copolymers with acidic groups, fumed silica, organic derivatives of castor oil and polyoxyethylene-polyoxypropylene block copolymers.

6. The composition according to any one of claims 1-5, wherein the composition further comprises one or more selected from photosensitizer consisting of amine compounds; photosensitizers consisting of thioxanethone, derivatives of thioxanethone, anthraquinone, derivatives of anthraquinone, anthracene, derivatives of anthracene, perylene, derivatives of perylene, benzophenone, benzoin isopropyl ether; reactive diluents; resins such as epoxy resin, polyamide, polyamideimide, polyurethane, polybutadiene, polychloroprene, polyether, polyester, styrene/butadiene styrene block copolymer, petroleum resin, xylene resin, ketone resin, cellulose resin, fluorine containing oligomer, and silicon containing oligomer; polymerization inhibitors; polymerization initiation assistants, levelling agents; wettability improvers; surfactants; plasticizers; UV absorbers; silane coupling agents; resin particles; pigments; and dyes.

7. The radiation curable composition according to any one of the preceding claims, wherein the composition comprises cationically curable components, and radically curable components.

8. The radiation curable composition according to any one of the preceding claims, wherein the composition comprises between 5 and 50 wt% of radically polymerizable components.

## Patentansprüche

1. Viskositätsreduzierbare, durch Bestrahlung härtbare Zusammensetzung zur Herstellung dreidimensionaler Objekte, umfassend:
5-70 Gew.-% einer difunktionellen Epoxidverbindung;
0,1-15 Gew.-% eines Acrylats mit einer Funktionalität größer als 2;
0,1-10 Gew.-% eines Thixotropiermittels;
0,01-5 Gew.-% eines Fließmodifizierers, der ein Polyalkylenoxidmodifiziertes Polydimethylsiloxan istt;
10-90 Gew.-% eines Füllstoffs; und
mindestens einen Photoinitiator.

2. Zusammensetzung nach Anspruch 1, wobei die Zusammensetzung die Eigenschaften aufweist:
i) einen Fließspannungswert von < 1000 Pa
ii) eine Viskosität (bei einer Reißgeschwindigkeit von 1 Sek.⁻¹) zwischen 0 und 1500 Pa s, und
iii) eine Füllstoff-Sinkgeschwindigkeit von weniger als 0,3 mm/Tag.

3. Zusammensetzung nach Anspruch 1 oder 2, wobei die difunktionelle Epoxidverbindung ausgewählt aus der Gruppe bestehend aus Bisphenol-A-Diglycidylether, Bisphenol-F-Diglycidylether, hydriertem Bisphenol-A-Diglycidylether, hydriertem Bisphenol-F-Diglycidylether, 3,4-Epoxycyclohexylmethyl-3',4'-epoxycyclohexancarboxylat, Bis(3,4-Epoxycyclohexylmethyl)adipat, 1,4-Butandioldiglycidylether, 1,6-Hexandioldiglycidylether, Polyethylenglycoldiglycidylether und Polypropylenglycoldiglycidylether.

4. Zusammensetzung nach einem der Ansprüche 1-3, wobei das Acrylat mit einer Funktionalität von größer als 2 ausgewählt ist aus der Gruppe bestehend aus Trimethylolpropan-Tri(meth)acrylat, Ethylenoxidmodifiziertem Trimethylolpropan Tri(meth)acrylat, Dipentaerythritol Hexa(meth)acrylat, Dipentaerythritol Penta(meth)acrylat und Ditrimethylolpropan Tetra(meth)acrylat.

5. Zusammensetzung nach einem der Ansprüche 1-4, wobei das Thixotropiermittel ausgewählt ist aus der Gruppe bestehend aus Polyvinylpyrrolidon, Titanat-Kopplungsmitteln, Aluminiumdistearat, Aluminiumtristearat, Copolymeren mit Säuregruppen, rauchender Kieselsäure, organischen Derivaten von Rizinusöl und Polyoxyethylen-Polyoxypropylen-Blockpolymeren.

6. Zusammensetzung nach einem der Ansprüche 1-5, wobei die Zusammensetzung ferner eines oder mehr ausgewählt aus Photosensibilisierern bestehend aus Aminverbindungen; Photosensibilisierern bestehend aus Thioxanethon, Derivaten von Thioxanethon, Anthraquinon, Derivaten von Anthraquinon, Anthracen, Derivaten von Anthracen, Perylen, Derivaten von Perylen, Benzophenon, Benzoinisopropylether; reaktiven Verdünnern; Harzen wie Epoxidharz, Polyamid, Polyamidimid, Polyurethan, Polybutadien, Polychloropren, Polyether, Polyester, Styrol/Butadienstyrol-Block-Copolymer, Petroleumharz, Xylenharz, Ketonharz, Zelluloseharz, fluorhaltigem Oligomer und silikonhaltigem Oligomer; Polymerisationshemmern; Polymerisations-Initiierungshilfsstoffen, Verlaufsmitteln; Benetzungsverbesserern; Tensiden; Weichmachern; UV-Absorbern; Silan-Kopplungsmitteln; Harzteilchen; Pigmenten und Farbstoffen umfasst.

7. Durch Bestrahlung härtbare Zusammensetzung nach einem der vorhergehenden Ansprüche, wobei die Zusammensetzung kationisch härtbare Komponenten und radikalisch härtbare Komponenten umfasst.

8. Durch Bestrahlung härtbare Zusammensetzung nach einem der vorhergehenden Ansprüche, wobei die Zusammensetzung zwischen 5 und 50 Gew.-% an radikalisch polymerisierbaren Komponenten umfasst.

## Revendications

1. Composition durcissable par rayonnement réductible en viscosité pour produire des objets tridimensionnels comprenant 5-70 % en poids d'un composé époxyde difonctionnel ;
0,1-15 % en poids d'un acrylate ayant une fonctionnalité supérieure à 2 ;
0,1-10 % en poids d'un agent thixotrope ;
0,01-5 % en poids d'un modificateur d'écoulement qui est un polydiméthylsiloxane modifié par un poly(oxyde d'alkylène) ;
10-90 % en poids d'une charge ; et
au moins un photoinitiateur.

2. Composition selon la revendication 1, où la composition a les propriétés :
i) une valeur de contrainte d'écoulement plastique < 1 000 Pa,
ii) une viscosité (à un gradient de cisaillement de 1 s⁻¹) entre 0 et 1 500 Pa.s, et
iii) une vitesse de sédimentation de charge inférieure à 0,3 mm/jour.

3. Composition selon la revendication 1 ou 2, où le composé époxyde difonctionnel est choisi dans le groupe consistant en le diglycidyléther de bisphénol A, le diglycidyléther de bisphénol F, le diglycidyléther de bisphénol A hydrogéné, le diglycidyléther de bisphénol F hydrogéné, le carboxylate de 3,4-époxycyclohexylméthyl-3',4'-époxycyclohexane, l'adipate de bis(3,4-époxycyclohexylméthyle), le diglycidyléther de 1,4-butanediol, le diglycidyléther de 1,6-hexanediol, le diglycidyléther de polyéthylèneglycol et le diglycidyléther de polypropylèneglycol.

4. Composition selon l'une quelconque des revendications 1-3, où l'acrylate ayant une fonctionnalité supérieure à 2 est choisi dans le groupe consistant en le tri(méth)acrylate de triméthylolpropane, le tri(méth)acrylate de triméthylolpropane modifié par l'oxyde d'éthylène, l'hexa(méth)acrylate de dipentaérythritol, le penta(méth)acrylate de dipentaérythritol et le tétra(méth)acrylate de ditriméthylolpropane.

5. Composition selon l'une quelconque des revendications 1-4, où l'agent thixotrope est choisi dans le groupe consistant en la polyvinylpyrrolidone, les agents de couplage titanates, le distéarate d'aluminium, le tristéarate d'aluminium, les copolymères avec des groupes acides, la silice fumée, les dérivés organiques de l'huile de ricin et les copolymères séquencés polyoxyéthylène-polyoxypropylène.

6. Composition selon l'une quelconque des revendications 1-5, où la composition comprend en outre un ou plusieurs choisis parmi les photosensibilisateurs consistant en les composés amines ; les photosensibilisateurs consistant en la thioxanéthone, les dérivés de la thioxanéthone, l'anthraquinone, les dérivés de l'anthraquinone, l'anthracène, les dérivés de l'anthracène, le pérylène, les dérivés du pérylène, la benzophénone, l'isopropyléther de benzoïne ; les diluants réactifs ; les résines comme une résine époxyde, un polyamide, un polyamideimide, un polyuréthane, un polybutadiène, un polychloroprène, un polyéther, un polyester, un copolymère séquencé styrène/butadiène styrène, une résine de pétrole, une résine de xylène, une résine de cétone, une résine de cellulose, un oligomère contenant du fluor et un oligomère contenant du silicium ; les inhibiteurs de polymérisation ; les auxiliaires d'initiation de polymérisation, les agents nivelants ; les agents améliorant la mouillabilité ; les tensioactifs ; les plastifiants ; les absorbeurs d'UV ; les agents de couplage silanes ; les particules de résine ; les pigments ; et les colorants.

7. Composition durcissable par rayonnement selon l'une quelconque des revendications précédentes, où la composition comprend des composants durcissables par voie cationique et les composants durcissables par voie radicalaire.

8. Composition durcissable par rayonnement selon l'une quelconque des revendications précédentes, où la composition comprend entre 5 et 50 % en poids de composants polymérisables par voie radicalaire.
